Europäisches Patentamt

European Patent Office

Office européen des brevets

(11) Numéro de publication: **0 270 447**

**A1**

## (12) DEMANDE DE BREVET EUROPEEN

(21) Numéro de dépôt: 87402636.2

(22) Date de dépôt: 24.11.87

(51) Int. Cl.⁴: **G 10 K 11/34**
H 01 L 41/04

(30) Priorité: 28.11.86 FR 8616662

(43) Date de publication de la demande:
08.06.88 Bulletin 88/23

(84) Etats contractants désignés: ES

(71) Demandeur: THOMSON-CSF
173, Boulevard Haussmann
F-75379 Paris Cédex 08 (FR)

(72) Inventeur: Reynier, René
THOMSON-CSF SCPI 19, avenue de Messine
F-75008 Paris (FR)

Gelly, Jean-François
THOMSON-CSF SCPI 19, avenue de Messine
F-75008 Paris (FR)

(74) Mandataire: Grynwald, Albert et al
THOMSON-CSF SCPI 19, avenue de Messine
F-75008 Paris (FR)

(54) Sonde d'échographe à arrangement d'éléments piézo-électriques.

(57) La liaison électrique entre les circuits de commande d'une sonde et les faces métallisées (6) des éléments (2) piézo-électriques de cette sonde est assurée par des métallisations (8) réalisées sur des pièces (4) au contact de ces faces métallisées. La liaison mécanique et électrique entre ces métallisations au contact est assurée par une mince couche de colle non conductrice. On montre que la couche de colle non conductrice est fluide, qu'elle peut être mise en oeuvre en très petite épaisseur (21), et que les aspérités apparaissant sur les métallisations au contact s'écrouissent les unes dans les autres et constituent une multitude de ponts électriques (22).

FIG_2

**Description**

SONDE D'ECHOGRAPHE A ARRANGEMENT D'ELEMENTS PIEZO-ELECTRIQUES.

La présente invention a pour objet une sonde d'échographe à arrangement d'éléments piézo-électriques. Elle trouve plus particulièrement son application dans le domaine médical où des échographes sont utilisés à des fins de diagnostic pour présenter des images de structures internes tissulaires de corps humains étudiés. Elle peut néanmoins être mise en oeuvre dans d'autres domaines dès qu'un contact électrique doit être assuré entre deux pièces à fixer par collage l'une contre l'autre.

De plus, la réalisation de sondes acoustiques à usage non médical comme par exemple des sondes sous-marines ne sort pas du cadre de la présente invention.

Un échographe comporte schématiquement un générateur de signaux électriques et une sonde transductrice, raccordée au générateur, pour appliquer une vibration acoustique, correspondant à ces signaux, dans un milieu à étudier. Pendant des arrêts de l'émission la sonde peut être utilisée d'une manière réversible pour recevoir des signaux acoustiques rétrodiffusés par le milieu, et pour transformer ces signaux en des signaux électriques. Ultérieurement les signaux reçus peuvent être introduits dans des moyens de réception et de traitement. Pour diverses raisons, notamment pour des questions de résolution de l'image restituée par l'échographe, la fréquence de travail du signal électrique - acoustique est élevée. Pour ces mêmes raisons la sonde est constituée d'une pluralité d'éléments transducteurs alignés les uns contre les autres. A ces fréquences de travail les dimensions des éléments sont faibles. Elles entrainent des difficultés de réalisation du système de connexion électrique des éléments piézo-électriques aux circuits de commande de la sonde. En effet chaque élément piezoélectrique comporte deux métallisations, situées sur des faces opposées de cet élément, qui doivent être reliées aux circuits d'émission-reception de l'échographe.

Il est connu, notamment dans une demande de brevet Européen no 84 308 373.4 déposée le 03 DECEMBRE 1984, d'appliquer ou de prélever le signal électrique aux bornes de chaque élément transducteur en soudant des pistes de liaison électrique, supportées par un circuit imprimé souple, directement contre les métallisations des éléments transducteurs. Ultérieurement les circuits imprimés souples sont repliés vers l'arrière de la sonde et, par des dispositions diverses, la sonde est de plus courbée pour correspondre à une utilisation particulièrement recherchée d'exploration du milieu étudié : par balayage sectoriel. Cette réalisation présente de nombreux inconvénients et il a été imaginé de les résoudre en adjoignant, de part et d'autre de chaque élément transducteur, un bloc relais métallisé continuement sur au moins deux de ses faces adjacentes. Le bloc relais peut alors être relié électriquement par une de ses faces à l'une des faces de l'élément transducteur et par son autre face à un circuit de connexion du type circuit imprimé.

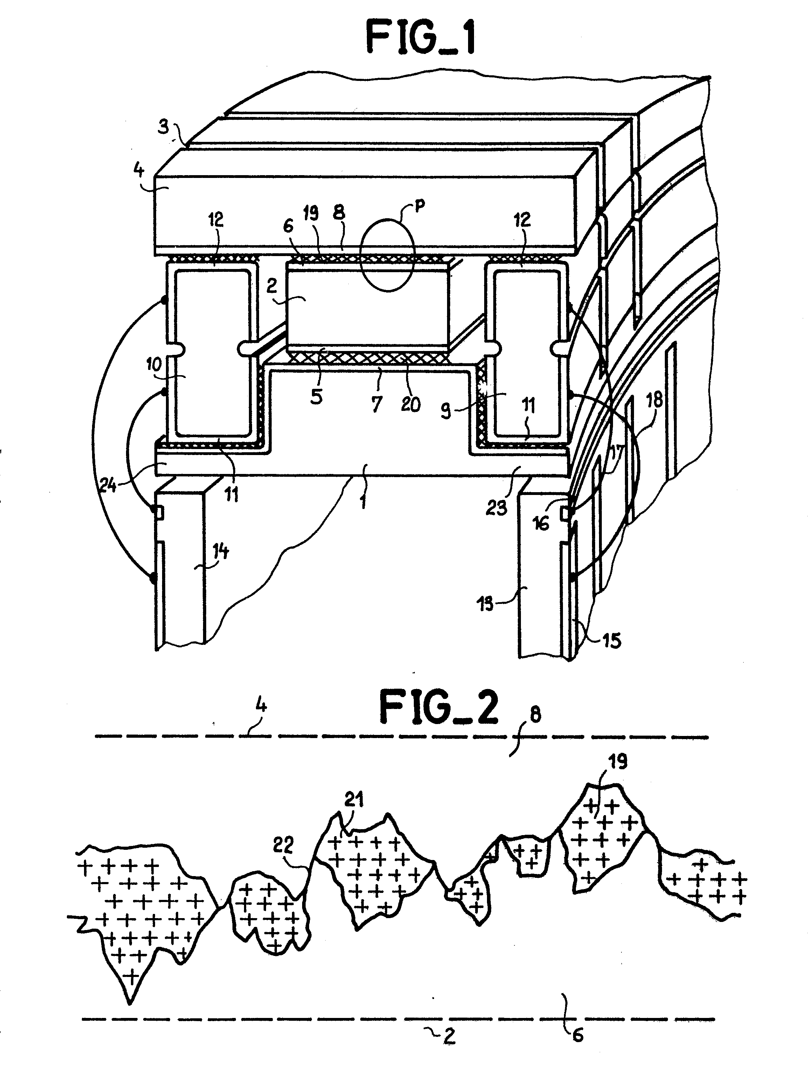

Pour ce circuit imprimé les problèmes de courbure de la barrette n'interviennent plus puisque ses connexions peuvent être faites après courbure de cette barrette. Un exemple d'une telle réalisation est montrée sur la figure 1.

Il a été envisagé de relier par des fils de liaisons les faces correspondantes des blocs et des éléments. Cette opération de micro-connexion est cependant délicate à entreprendre. Elle est coûteuse. Dans une réalisation il a été mis à profit le fait que les éléments piézo-électriques peuvent être recouverts d'une lame de transition qui permet l'adaptation de la transmission du signal acoustique au milieu à étudier. Cette lame peut avoir la particularité d'être métallisée sur sa face en regard de l'élément piézo-électrique qu'elle couvre. Cette lame peut déborder par ailleurs de l'élément piézo-électrique et vient recouvrir également le bloc relais qui sert pour la liaison électrique. Les signaux électriques sont donc successivement conduits du circuit imprimé au bloc relais, à la métallisation de la lame, puis enfin à la métallisation de l'élément piézo-électrique et vice versa en reception.

Il est cependant apparu qu'un problème supplémentaire subsistait. En effet la lame doit être collée à son élément : elle ne tient pas toute seule. Il a donc été envisagé de coller la lame à son élément (et aussi au bloc relais) par une couche de colle conductrice. Si électriquement cette solution est satisfaisante, acoustiquement elle est rédhibitoire. En effet la couche de colle ne peut pas présenter une impédance acoustique adaptée à la transmission des ondes acoustiques. Elle constitue donc une surface de réflexion pour ces ondes acoustiques ; et ceci provoque des désordres dans l'image de l'échographe. Une autre solution consistant à ne pas métalliser les faces des éléments piézo-électriques, mais à induire le champ électrique dans chaque élément par la tension appliquée entre les métallisations de la lame et du support de cet élément est inexploitable. En effet ces pièces doivent être collées ensemble, et quelle que soit l'épaisseur de la colle mise en oeuvre, la constante diélectrique de cette colle étant différente de la constante diélectrique du cristal, le phénomène de piézo-électricité est perturbé. La transformation électrique-acoustique, ou vice-versa, se produit mal.

Dans l'invention on remédie à ces inconvénients en utilisant une couche de colle non conductrice. Mais contrairement à ce à quoi on pouvait s'attendre, la couche de colle non conductrice ne constitue pas un écran isolant total pour la liaison électrique. En effet les colles non conductrices présentent la particularité d'être très fluides. Elles peuvent donc être mises en oeuvre en très fine épaisseur. En utilisant alors les défauts d'aspect des métallisations, qui confèrent à ces métallisations un aspect microscopiquement granulé, on peut, en exerçant une pression suffisante lors du collage des pièces par leur partie métallisée, obtenir un écrouissage, une interpénétration molèculaire entre ces couches de métallisation. De cette façon la liaison entre ces couches peut être considérée comme une dispersion d'une multitude de ponts électriques entre des liaisons mécaniques provoquées par la présence de la colle. De plus, comme la couche de colle isolante est très mince, l'énergie électrique est transmise à travers le condensateur formé par les métallisations et par la colle.

L'invention concerne donc une sonde, par exemple d'échographe à arrangement d'éléments piézo-électriques, chaque élément étant maintenu sur un support, ou/et étant recouvert d'une lame de transition acoustique, et étant métallisé sur ses faces en regard du support et de la lame, caractérisée en ce que le support et/ou la lame comportent des métallisations correspondant aux métallisations de chaque élément et en ce qu'une mince couche de colle non conductrice est interposée entre ces métallisations correspondantes pour assurer une continuité électrique.

L'invention sera mieux comprise à la lecture de la description qui suit et à l'examen des figures qui l'accompagnent. Elles ne sont données qu'à titre indicatif et nullement limitatif de l'invention. Les figures montrent:

- figure 1 : en perspective, une sonde d'échographe conforme à l'invention,
- figure 2 : en coupe, un détail d'une partie de la figure 1 montrant schématiquement l'effet de l'invention.

La figure 1 représente en partie une sonde d'échographe à arrangement d'éléments piézo-électriques conforme à l'invention. Dans l'exemple l'arrangement est une barrette. Cette sonde comporte un support 1 commun à une pluralité d'éléments transducteurs tels que 2. Les éléments transducteurs sont séparés les uns des autres par des séparations telles que 3. Chaque élément est recouvert par une lame 4 dite de transition acoustique et possède sur ses faces en regard du support et de la lame une métallisation respectivement 5 et 6. Dans l'invention le support et la lame comportent également des métallisations respectivement 7 et 8. Ces métallisations sont destinées à être connectées aux métallisations des éléments. Dans un exemple préféré de réalisation, le dispositif de liaison électrique des éléments comporte, de part et d'autre de chaque élément, un bloc relais parallélépipèdique tel que 9 ou 10. Les blocs sont réalisés en un matériau isolant, par exemple en une céramique. Ils sont métallisés sur leur surface par deux métallisations électriquement indépendantes, respectivement 11 et 12 pour chaque bloc. Les signaux électriques sont conduits entre les circuits électroniques de la sonde (non représentés) et les éléments piézo-électriques par des circuits imprimés tels que 13 et 14, dont les pistes 15 ou 16 sont reliées par des liaisons 17, 18 aux faces latérales métallisées et électriquement indépendantes des blocs 9 et 10.

Ce qui caractérise la présente invention est la présence, pour conduire ces signaux électriques, entre les métallisations 6 et 8 d'une part, et/ou entre les métallisations 5 et 7 d'autre part, de minces couches respectivement 19 et 20 de colle non conductrice. La figure 2 est un agrandissement d'une partie P de la liaison entre la face supérieure d'un élément piézo-électrique et la face inférieure de la lame de transition qui le recouvre. La figure 2 montre que les métallisations 6 et 8 de ces deux pièces ne sont pas parfaitement lisses. Elles présentent par contre des aspérités microscopiques. Dans l'invention on répand une couche de colle non conductrice 19 avant l'assemblage de ces pièces. On exerce ensuite sur elles une pression suffisante, par exemple de l'ordre de 50 kgf par cm2. La colle très fluide s'échappe alors sur les côtés du collage, ne laissant en place que des minuscules liaisons mécaniques 21 parmis lesquelles est dispersée une multitude de ponts électriques 22. Dans ces conditions la liaison électrique est bonne entre la métallisation 8 et la métallisation 6. De plus le couplage acoustique entre l'élément 2 et sa lame 4 est direct. Les métallisations sont de préférence obtenues par évaporation - projection, sous vide, d'un métal. Elles peuvent aussi être obtenues par électrolyse. L'aspect microscopique granuleux est obtenu naturellement, sans précaution particulière.

D'une manière préférée la colle non conductrice est une colle structurale, donc à très haut pouvoir d'adhésion, et elle est en plus une colle dite à haute température, c'est-à-dire très stable à basse température ou à température ambiante mais très fluide à sa (haute) température de mise en oeuvre.

Une barrette d'éléments piézo-électriques est fabriquée de la manière suivante : sur un support 1 alongé, dont le profil est en forme de T, et dont la surface supérieure est préalablement métallisée, on place, d'une manière préférée selon l'invention avec une couche de colle non conductrice, un barreau d'un matériau piézo-électrique métallisé sur ses deux faces. Puis on place sur les deux ailes 23 et 24 du support 1, des réglettes comportant deux métallisations électriquement indépendantes : là aussi de préférence en utilisant une couche de colle non conductrice. Enfin on colle une lame, métallisée sur sa face en regard, et dont la longueur est la même que celle du support, que celle du barreau piézo-électrique, et que celles des réglettes au dessus du tout. On soumet l'ensemble à une pression suffisante et on laisse prendre la colle. Lorsque la prise est terminée, on exécute les découpes 3, par exemple à la scie, pour séparer la barrette, l'arrangement, en de multiples éléments indépendants. Pour constituer une barrette courbe, il suffit alors de courber le support 1 dans la forme voulue. L'invention apporte un autre avantage inattendu. L'usage de colle non conductrice permet d'éliminer tout risque de court-circuit entre les différentes métallisations qui apparaissait dans l'état de la technique cité, du fait de l'utilisation de colles conductrices. Il en résulte que le rendement de fabrication des sondes est considérablement augmenté avec l'invention.

Il n'est cependant pas nécessaire d'exécuter toutes les liaisons électriques des éléments de la barrette avec le procédé décrit. En particulier les liaisons entre la métallisation 5 et la métallisation 7 à l'endroit du support ne sont pas nécessairement réalisées avec une couche de colle non conductrice. A cet endroit en effet, les réflexions parasites des vibrations acoustiques se produisent dans une direction non utile, vers l'arrière de la barrette. Elles sont donc moins génantes.

## Revendications

1 - Sonde d'échographe à arrangement d'éléments (2) pièzo-électriques, chaque élément étant maintenu sur un support (1), ou/et étant recouvert d'une lame (4) de transition acoustique, et étant métallisé (5,6) sur ses faces en regard du support et de la lame, caractérisée en ce que le support et/ou la lame comportent des métallisations (7,8 ) correspondant aux métallisations de chaque élément et en ce qu'une mince couche de colle non conductrice (20,19) est interposée entre ces métallisations correspondantes pour assurer une continuité électrique.

2 - Sonde selon la revendication 1, caractérisée en ce que les métallisations correspondantes à coller comportent un aspect de surface favorable à leur écrouissage les unes dans les autres (Fig 2).

3 - Sonde selon la revendication 1 ou la revendication 2, caractérisée en ce que le support est commun à plusieurs éléments.

4 - Sonde selon l'une quelconque des revendications 1 à 3 caractérisé en ce que l'arrangement d'éléments est une barrette.

5 - Sonde selon la revendication 4, caractérisée en ce que la barette est courbe.

6 - Sonde selon la revendication 3 caractérisée en ce que la lame de chaque élément et le support commun débordent latérallement (23,24) des éléments et enserrent, à l'endroit de chaque élément, au moins un relais (9,10) de liaison électrique.

7 - Sonde selon la revendication 6 caractérisée en ce que le relais comporte un parallélépipède muni d'au moins une métallisation (11, 12) continue réalisée sur au moins deux de ses faces contigües.

8 - Sonde selon la revendication 7, caractérisée en ce que la métallisation du parallélépipède est collée avec une colle non conductrice (19,20) au support et/ou à la lame.

9 - Sonde selon la revendication 3, caractérisée en ce que le support est en un matériau thermo-déformable thermo-déformé.

10 - Sonde selon l'une quelconque des revendications précédentes, caractérisée par le fait que ladite sonde est une sonde d'échographie.

0270447

FIG_1

FIG_2

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | EP-A-0 005 265 (SIEMENS AG) <br> * Page 1, ligne 5 - page 2, ligne 22; page 4, ligne 20 - page 5, ligne 31; revendication 1 * <br> --- | 1,2 | G 10 K 11/34 <br> H 01 L 41/04 |
| A | US-A-4 276 491 (K.P. DANIEL) <br> * Colonne 5, lignes 46-67 * <br> --- | 1,10 | |
| D,A | EP-A-0 145 429 (TOSHIBA) <br> * Résumé * <br> --- | 3-5,10 | |
| A | PATENT ABSTRACTS OF JAPAN, vol. 7, no. 27 (E-156)[1172], 3 février 1983; & JP-A-57 181 299 (YOKOGAWA DENKI SEISAKUSHO K.K.) 08-11-1982 <br> * En entier * <br> ----- | 9 | |

|   |   |
|---|---|
|   | DOMAINES TECHNIQUES RECHERCHES (Int. Cl.4) <br><br> G 10 K <br> H 01 L |

Le présent rapport a été établi pour toutes les revendications

| Lieu de la recherche | Date d'achèvement de la recherche | Examinateur |
|---|---|---|
| LA HAYE | 29-02-1988 | HAASBROEK J.N. |

EPO FORM 1503 03.82 (P0402)